# EUROPEAN PATENT APPLICATION

(11) **EP 1 785 706 A1**
(43) Date of publication of application: **16.05.2007**
(21) Application number: 05110735.7
(22) Date of filing: 15.11.2005
(51) Int. Cl.: G01L 1/22

(54) **Method for producing an electric circuit on a flexible substrate**

(71) Applicant: IEE INTERNATIONAL ELECTRONICS & ENGINEERING S.A., 6468 Echternach (LU)
(72) Inventor: Schumacher, Alain, 54298 Igel (DE); Chabach, Driss, 9676, Noertrange (LU)
(74) Representative: Beissel, Jean

(57) **Abstract**

A method for producing an electric circuit on a flexible substrate, comprises the sequence of steps:
a. providing a flexible substrate;
b. applying a layer of resistive material on said flexible substrate;
c. applying a conductive layer at least partially on said layer of resistive material.

## Description

### Technical field

The present invention generally relates to electrical circuits on flexible substrates, as used e.g. in foil-type sensors. More particularly, the invention relates to a method for producing such a circuit.

### Background Art

In sensor production, a common method of producing electric circuits involves printing technology using conductive polymer thick film layers with conductive or semi-conductive particles, e.g. silver, copper or graphite. The silver print is used for providing the conductive lines of the flexible sensor, while the graphite or carbon print is used for providing resistive elements of the sensor circuit, such as printed resistors, pressure sensitive layers, etc.

As the sensor has certain flexibility, the layers forming the electric circuits of the sensor should have an appropriate robustness with regard to bending, tensile stress, compressive stress or shear stress of the sensor. Increasing the mechanical robustness of the electric circuits thus would be beneficial for the overall durability of the sensor and provide improved sensor reliability.

### Object of the invention

It is an object of the present invention to provide an electric circuit on a flexible substrate with improved mechanical robustness.

This object is achieved by a method as claimed in claim 1.

### General Description of the Invention

According to the invention, a method for producing an electric circuit on a flexible substrate comprises the sequence of steps:
a. providing a flexible substrate, e.g. a PET foil, a PEN foil, a Pl foil, a PEEK foil, a PES foil or a PPS foil, etc.;
b. applying a layer of resistive material on said flexible substrate;
c. applying a conductive layer partially on said layer of resistive material.

As the skilled person will notice, the present method breaks with a paradigm: instead of applying the layer of resistive material on the conductive layer, the invention proposes to reverse the order of application and apply the conductive layer on top of the layer of resistive material, for instance, directly on the layer of resistive material. Surprisingly, it has been found that by this simple measure, the mechanical robustness of the circuit on the flexible substrate can be significantly improved. Reduction of chemical and mechanical stress caused to the conductive layer during curing of the resistive layer may be an explanation for this unexpected effect.

According to a preferred embodiment of the invention, it is proposed a method for producing a pressure sensor component, the component having a patch of resistive material on a flexible substrate and a conductive line formed by a conductive layer for contacting the patch to a control and evaluation circuit. The method comprises the sequence of steps a), b) and c) as above.

As will be appreciated, the higher robustness of the circuits enables production of more robust and more reliable sensors components (and hence sensors), e.g. for the automotive or aeronautical industries.

It shall be noted that the conductive layer may cover the layer of resistive material partly or entirely.

Preferably, steps c) and/or d) involve printing of the layer of resistive material, respectively of the conductive layer.

Most preferably, the layer of resistive material comprises or consists of carbon ink, whereas the conductive layer comprises or consists of a polymer layer with metal particles, e.g. a silver ink.

### Brief Description of the Drawings

Further details and advantages of the present invention will be apparent from the following detailed description, with reference to the attached drawings, wherein:
Fig. 1: is a cross-sectional view of a component of a flexible sensor produced by the common method;
Fig. 2: is a cross-sectional view of a component of a flexible sensor produced according to the present invention.
Fig. 3: is a top view of the flexible sensor component of Fig. 2.

### Description of Preferred Embodiments

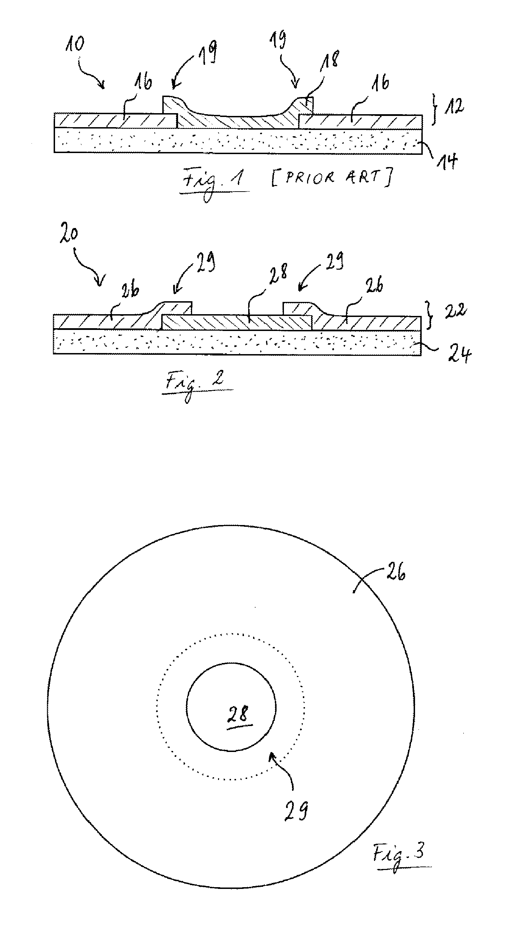

Fig. 1 shows a cross-sectional view of part of a flexible sensor component 10 produced by a prior art method. The sensor component 10 comprises an electric circuit formed 12 on a substrate 14. The electric circuit comprises a conductive layer 16, e.g. a silver layer and a resistive layer 18, e.g. consisting of carbon ink. As can be seen in Fig. 1, the resistive layer 18 partly overlaps the conductive layer 16 in a connection region 19.

Fig. 2 shows a cross-sectional view of part of a flexible sensor component 20, produced in accordance with the present invention. The sensor component 20 comprises an electric circuit 22 formed on a substrate 24. The electric circuit 22 comprises a conductive layer 26, formed e.g. of a silver ink, and a resistive layer 28, e.g. consisting of carbon ink. As the conductive layer has been applied later than the resistive layer, the conductive layer 26 is applied partially and top of the resistive layer 18 and partially on the substrate 24. The conductive layer 26 thus overlaps the resistive layer 28 in the connection region 29. Fig. 3 shows a top view of the arrangement of Fig. 2. As will be appreciated, the sensor component of Figs. 2 and 3 has improved mechanical strength compared to the sensor component of Fig. 1.

## Claims

1. A method for producing an electric circuit on a flexible substrate, comprising the sequence of steps:
a. providing a flexible substrate;
b. applying a layer of resistive material on said flexible substrate;
c. applying a conductive layer at least partially on said layer of resistive material.

2. A method for producing a pressure sensor component, said component having a patch of resistive material on a flexible substrate and a conductive line formed by a conductive layer for contacting said patch to a control and evaluation circuit, the method comprising the sequence of steps:
a. providing said flexible substrate;
b. applying said layer of resistive material on said flexible substrate;
c. applying said conductive layer at least partially on said layer of resistive material.

3. The method according to claim 1 or 2, wherein said resistive material comprises carbon ink.

4. The method according to any one of claims 1 to 3, wherein said conductive layer comprises a silver ink.

5. The method according to any one of claims 1 to 4, wherein said conductive layer partly covers said layer of resistive material.

6. The method according to any one of claims 1 to 5, wherein said conductive layer layer entirely covers said layer of resistive material.

7. The method according to any one of claims 1 to 6, wherein said layer of resistive material is printed on said substrate.

8. The method according to any one of claims 1 to 7, wherein said conductive layer is applied directly on said layer of resistive material.

9. The method according to any one of claims 1 to 8, wherein said conductive layer is printed on said layer of resistive material.
